# EUROPEAN PATENT SPECIFICATION

(11) **EP 2 671 705 B1**
(45) Date of publication and mention of the grant of the patent: **09.08.2017**
(21) Application number: 13170844.8
(22) Date of filing: 06.06.2013
(51) Int. Cl.: B29C 65/16, G01V 8/10, B29L 31/34

(54) **PHOTOELECTRIC SENSOR, AND METHOD OF MANUFACTURING THE PHOTOELECTRIC SENSOR**
PHOTOELEKTRISCHER SENSOR UND VERFAHREN ZUR HERSTELLUNG DES PHOTOELEKTRISCHEN SENSORS
CAPTEUR PHOTOÉLECTRIQUE ET PROCÉDÉ DE FABRICATION DU CAPTEUR PHOTOÉLECTRIQUE

(30) Priority: 07.06.2012 JP 2012130048
(43) Date of publication of application: 11.12.2013
(73) Proprietor: OMRON CORPORATION, Kyoto-shi, Kyoto 600-8530 (JP)
(72) Inventor: Inoue Naoto, Kyoto-shi, Kyoto 600-8530 (JP); Morisaki, Yuzo, Kyoto-shi, Kyoto 600-8530 (JP); Ushiro, Yuki, Kyoto-shi, Kyoto 600-8530 (JP)
(74) Representative: Horn Kleimann Waitzhofer Patentanwälte PartG mbB

(56) References cited:
- EP-A2- 1 837 831
- EP-A2- 2 402 145
- DE-A1-102005 059 546
- JP-A- 2005 292 441
- JP-A- 2006 017 795
- US-A1- 2005 184 224
- US-A1- 2005 219 717

## Description

### BACKGROUND OF THE INVENTION

### 1. TECHNICAL FIELD

The present invention relates generally to a photoelectric sensor, and a method of manufacturing the photoelectric sensor.

### 2. RELATED ART

As a method of bonding resin by use of laser, for example, Japanese Laid-open Patent Publication No. 2000-218698 describes a method of bonding resin by use of laser, and an apparatus thereof, for example. This patent publication aims to enhance a finish (quality) of a coupled portion.

In the bonding method described in the above-described publication, a member transparent to laser beam is arranged close to a laser light source, while a member made of resin or another material absorbing laser beam is arranged apart from the laser light source as overlapped with the transparent member. A mask having an opening with a shape that should be bonded is arranged between the laser light source and the transparent member, and the laser beam is emitted through the mask.

Japanese Laid-open Patent Publication No. 2003-225946 describes a laser bonding method and a laser bonding apparatus that aim to achieve stable bonding.

The bonding method described in Japanese Laid-open Patent Publication No. 2003-225946 includes a step of pressing a bonded member transmitting laser from just above a vicinity of a coupled portion, which is irradiated with the laser, by using a pressing jig, and a step of irradiating the coupled portion with the laser from the oblique side of the pressing jig.

As described in the above-described patent publications, there has been known a bonding method in which a translucent resin material that can transmit laser light and an absorbent resin material that absorbs laser energy are superimposed with each other, and the laser light is emitted from the side close to the translucent resin material. In this bonding method, the surface of the absorbent resin material generates heat by the laser energy, and the heat is transmitted to the translucent resin material. Thus, both resin materials are melted, and bonded to each other.

On the other hand, according to a shape of a resin part that is to be produced with the bonding method described above, some laser light emitted from a laser head to the translucent resin material may be blocked by the resin part.

In this case, the portion of the resin part blocking the laser light might be melted or burned. Particularly, the portion of the resin part blocking the laser light is melted or burned on the position close to the focal point (the bonding surface of the resin material) of the laser light. This entails a problem of deteriorating quality of the resin part.

When energy is unevenly transmitted to the bonding surface because some of laser light is blocked, a complicated control of the irradiation energy of the laser light has to be made in order to avoid this situation. A method is considered in which the laser light is emitted from an oblique direction to the bonding surface in order to prevent the interference with the laser light. However, in this case, cost for facilities for the irradiation of the laser light may be increased, or the control of moving the laser head may become complicated.

EP 2 402 145 A2 discloses a method involving forming a connection region by arranging three components with corresponding end sections together such that the end section of the second component is provided between the first and third components. The connection region is irradiated with a laser beam, and the first and second components and the second and third components are connected with each other at the end sections. The end section of the second component is provided with a material that is transparent for the laser beam.

DE 10 2005 059546 A1 discloses a fluid filter apparatus comprising an upper half casing member made of laser light transmitting resin and a lower half casing member made of a resin incapable of transmitting laser light. Upper and lower flange portions are formed at the respective casing members to protrude outwards of a casing from respective peripheral walls. A housing concave part and upper contact face are formed in the lower face portion of the upper flange portion. A laser light is irradiated to the lower flange portion through the upper flange portion to weld the contact faces.

US 2005/219717 A1 discloses a lens unit where two or more transparent resin lenses are combined, at least one transparent resin lens contains infrared absorbent. When the lens unit is assembled, an infrared laser is emitted to a joined portion between the transparent resin lens and the other transparent resin lens. The emitted infrared ray is absorbed by the infrared absorbent, so that the transparent resin lenses are welded to each other. An opaque lens barrel which holds the entire lens unit and the transparent resin lenses are joined by welding.

US 2005/184224 A1 discloses a detecting apparatus comprising a light radiation unit and a light receiver unit disposed in a space defined between a first case and a second case. The first case is made of light-blocking material, and the second case is made of light-transmitting material. The first case and the second case have respective flanges that contact each other along the entire periphery. The flanges are laser-welded air-tightly by radiating laser light to the flange of the first case through the flange of the second case.

EP 1 837 831 A2 discloses a portable device. The portable device is for performing wireless communication with a predetermined communication subject and includes a circuit board, on which an electronic component used to perform wireless communication is mounted, and a case for accommodating the circuit board. The case includes a first case part and a second case part. The first case part has a non-transparent portion that is non-transparent to visible light and a transparent portion that is transparent to visible light, arranged adjacent to and outward from the non-transparent portion, and transmissible to laser light. The second case part is transparent to visible light and formed from a synthetic resin. The second case part absorbs laser light and is superimposed with the first case part in a state joined with the transparent portion.

### SUMMARY

The present invention has been devised to solve the problems described above, and an object thereof is to provide a photoelectric sensor having high quality and produced by a simple manufacturing process, and a method of manufacturing the photoelectric sensor.

In accordance with one aspect of the present invention, a photoelectric sensor includes the features of claim 1.

According to the photoelectric sensor configured as described above, although the laser light is partially blocked by the second member on the position where the side portion and the top portion cross each other when the intermediate member is bonded to the bonding surface of the first member by the irradiation of the laser light from the side of the intermediate member, the height from the bonding surface to the position blocking the laser light by the second member is the same for any position facing the bonding surface. Thus, this configuration can eliminate the concern that the second member is locally melted or burned due to the irradiation of the laser light, whereby the quality of the photoelectric sensor can be enhanced. This configuration also prevents the occurrence of variation in the energy of the laser light transmitted to the bonding surface, whereby the photoelectric sensor can be manufactured by a simple manufacturing process.

Preferably, the first member and the intermediate member are bonded along the annularly round bonding surface. Preferably, the side portion has a cross-section same as or similar to the round shape of the bonding surface, when the second member is cut along a plane parallel to the bonding surface. The photoelectric sensorthus configured can effectively prevent the occurrence of variation in the energy transmitted to the bonding surface during the scan of the laser light along the bonding surface.

Preferably, a chamfered portion is formed on the position where the side and the top cross each other. Preferably, the chamfered portion is formed by cutting the position where the side and the top cross each other in an inclined plane or in a curved plane.

The photoelectric sensor thus configured can effectively prevent the second member from being melted or burned on the position where the side portion and the top portion cross each other.

The photoelectric sensor according to the present invention r includes: at least either one of a light projecting unit emitting light and a light receiving unit receiving light; and a mirror that reflects the light emitted from the light projecting unit to an object to be detected, or reflects the light emitted from the light projecting unit to the object to be detected toward the light receiving unit. The first member is a body case storing at least either one of the light projecting unit and the light receiving unit. The second member is a cover member that stores the mirror, and that is fixed to the body case via the intermediate case.

According to the photoelectric sensor configured as described above, a photoelectric sensor with high quality manufactured by a simple manufacturing method can be realized.

Preferably, the mirror has a reflection surface reflecting light, and is stored in the cover member in order that the reflection surface extends obliquely with respect to the bonding surface. The photoelectric sensor configured to include the mirror that is obliquely arranged with respect to the reflection surface can bring the effect described above.

The method of manufacturing a photoelectric sensor according to the present invention is a method of manufacturing the photoelectric sensor described above. The method of manufacturing the photoelectric sensor includes: a step of bonding the intermediate member to the second member by welding; a step of positioning a laser head on a place facing the bonding surface with the intermediate member being superimposed on the bonding surface; and a step of irradiating the bonding surface with laser light across the second member, while relatively moving the laser head and the resin part to keep a relationship in which an optical axis of the laser light is orthogonal to the bonding surface.

The method of manufacturing the photoelectric sensor described above can prevent the complicated control for the irradiation energy of the laser light or for moving the laser head or the resin part, and can prevent the increase in the cost for a facility for the irradiation of the laser light.

As described above, the present invention can provide a photoelectric sensor having high quality and produced by a simple manufacturing process, and a method of manufacturing the photoelectric sensor.

### BRIEF DESCRIPTION OF THE DRAWINGS

Fig. 1 is a view illustrating an overall configuration of a photoelectric sensor according to an embodiment of the present invention;
Fig. 2 is a sectional view illustrating a sensor head of the photoelectric sensor in Fig. 1;
Fig. 3 is a sectional view illustrating another sensor head of the photoelectric sensor in Fig. 1;
Fig. 4 is a perspective view illustrating the sensor head in Fig. 3 as viewed from a direction of an arrow IV;
Fig. 5 is a perspective view illustrating the sensor head in Fig. 3 as viewed from a direction of an arrow V;
Fig. 6 is a sectional view illustrating the partially enlarged sensor head of the photoelectric sensor in Fig. 2;
Fig. 7 is a sectional view illustrating a modification of a chamfered portion formed on a cap cover;
Fig. 8 is a sectional view illustrating a first process in a method of manufacturing a resin case in Fig. 6;
Fig. 9 is a sectional view illustrating a second process in a method of manufacturing a resin case in Fig. 6;
Fig. 10 is a side view illustrating the second process in a method of manufacturing a resin case in Fig. 6;
Fig. 11 is a perspective view illustrating a process of a method of manufacturing a resin case according to a comparative example; and
Fig. 12 is a perspective view illustrating a process of another method of manufacturing a resin case according to a comparative example.

### DETAILED DESCRIPTION

An embodiment of the present invention will be described with reference to the drawings. In each drawing, like parts or corresponding parts are designated by like reference numerals.

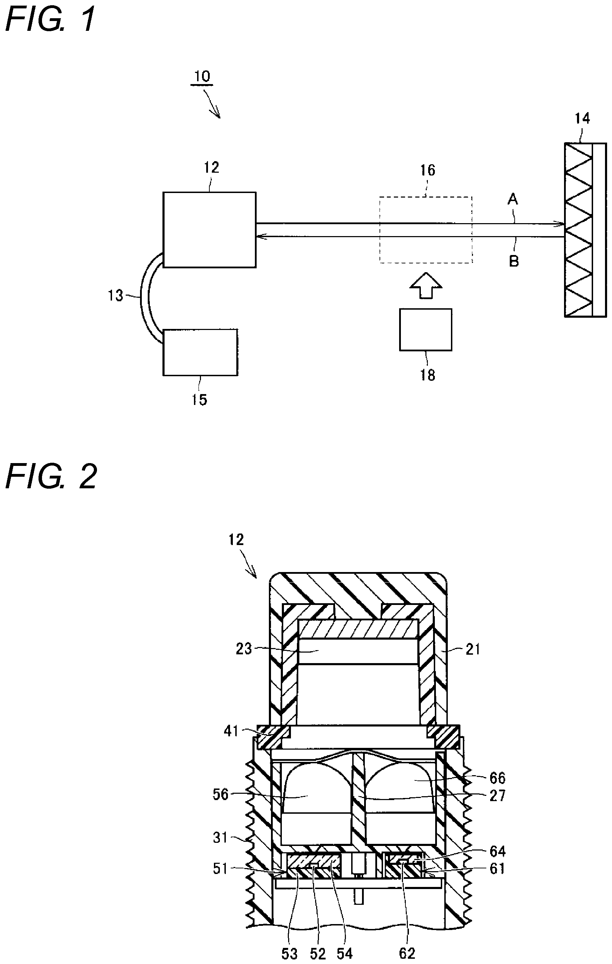

Fig. 1 is a view illustrating an overall configuration of a photoelectric sensor according to an embodiment of the present invention. An overall configuration of a photoelectric sensor 10 will firstly be described with reference to Fig. 1. The photoelectric sensor 10 includes a sensor head 12 and a retroreflector 14.

The sensor head 12 generates detection light A that is parallel light. The retroreflector 14 is arranged to face the sensor head 12. The detection light A emitted from the sensor head 12 is reflected by the retroreflector 14 to become return light B. The detection light A is visible light, for example. However, the wavelength region of the detection light A is not particularly limited, so long as the detection light A is retroreflected by the retroreflector 14.

The retroreflector 14 is formed with a lot of corner cubes. The detection light A is reflected by three surfaces of the retroreflector 14 to finally become the return light B. The return light B is light in the direction of the axis same as the detection light A, and advances in the direction reverse to the advancing direction of the detection light A on the route parallel to the route of the detection light A.

The sensor head 12 receives the return light B, and generates an electric signal having intensity corresponding to the amount of the received return light B. The sensor head 12 is connected to an amplifier unit 15 through a cable 13 collectively including a power source line and signal line, and outputs the generated electric signal to the amplifier unit 15 via the cable 13.

In the photoelectric sensor illustrated in Fig. 1, the sensor head 12 and the amplifier unit 15 are provided separately. However, the amplifier may be incorporated in the sensor head 12.

The amplifier unit 15 feeds driving voltage to the sensor head 12 via the cable 13. The sensor head 12 generates the detection light A and generates the electric signal indicating the amount of the received return light B on receipt of this driving voltage. The amplifier unit 15 also receives the signal from the sensor head 12 via the cable 13. The amplifier unit 15 detects the presence of an object based upon the signal, and outputs a signal indicating an amount of the received light by the sensor head 12.

The photoelectric sensor 10 detects the presence of an object based upon the amount of the light received by the sensor head 12. When an object 18 to be measured is not present on a region 16 on an optical path of the detection light A, the detection light A emitted from the sensor head 12 is reflected by the retroreflector 14 to become the return light B, and incident on the sensor head 12. On the other hand, when the object 18 to be measured is present on the region 16, the detection light A from the sensor head 12 is blocked by the object 18 to be measured. Therefore, the amount of the return light B received by the sensor head 12 decreases.

As described above, in the photoelectric sensor 10, the amount of the light received by the sensor head 12 is different depending upon whether the object 18 to be measured is located on the region 16. Thus, the photoelectric sensor 10 detects the presence of the object based upon the amount of the received light. The amplifier unit 15 detects whether the object 18 to be measured is present on the region 16 on receipt of the electric signal indicating the amount of the received light from the sensor head 12, e.g., by comparing the amount of the received light with a predetermined threshold value.

The photoelectric sensor 10 according to the present embodiment is a retroreflective photoelectric sensor with two lenses having a light projecting path and a light receiving path in the sensor head 12, the light projecting path and the light receiving path being physically separated. A more specific configuration of the photoelectric sensor 10 will be described next.

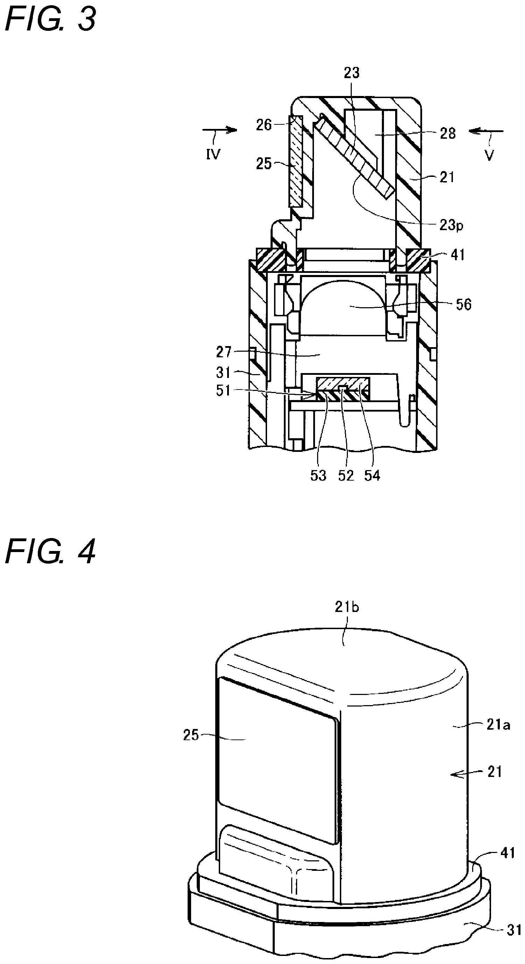

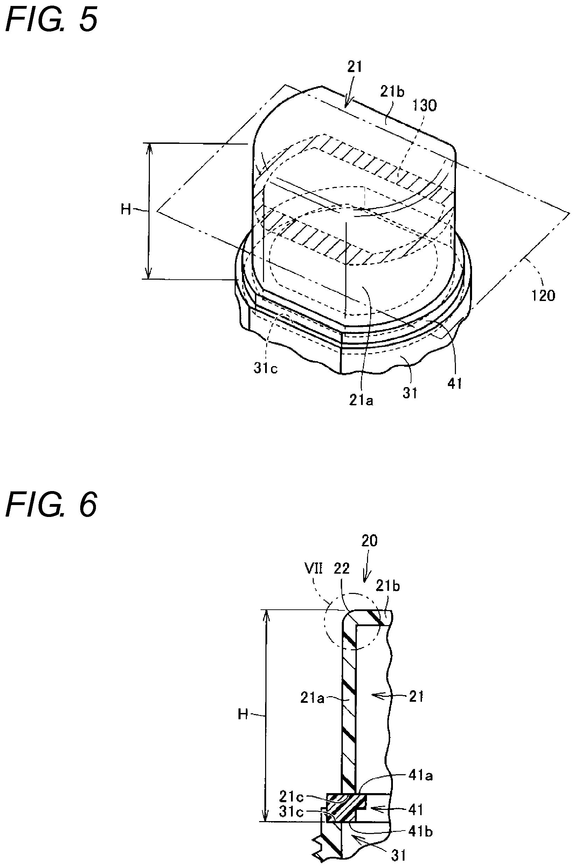

Fig. 2 is a sectional view illustrating a sensor head of the photoelectric sensor in Fig. 1. Fig. 3 is a sectional view illustrating another sensor head of the photoelectric sensor in Fig. 1. Fig. 4 is a perspective view illustrating the sensor head in Fig. 3 as viewed from a direction of an arrow IV. Fig. 5 is a perspective view illustrating the sensor head in Fig. 3 as viewed from a direction of an arrow V.

With reference to Figs. 2 to 5, the sensor head 12 of the photoelectric sensor 10 includes a light emitting diode 61, a photodiode 51, a light projecting lens 66, a light receiving lens 56, a reflection mirror 23, a case 31, an intermediate case 41, a cap cover 21, and a protection cover 25.

The case 31, the intermediate case 41, and the cap cover 21 are combined to one another to form a cylindrical shape that is an appearance of the sensor head 12. The case 31 is cylindrical with one end open, and stores the light emitting diode 61, the photodiode 51, the light projecting lens 66, and the light receiving lens 56. The cap cover 21 has a cap-like shape for closing the open end of the case 31, and stores the reflection mirror 23. The intermediate case 41 has an annular shape, and is provided between the case 31 and the cap cover 21.

The intermediate case 41 is made of resin. The intermediate case 41 is made of a translucent resin material that can transmit laser light. Examples of the translucent resin material include polypropylene (PP), polyamide (PA), polyethylene (PE), polycarbonate (PC), ABS resin, polybutylene terephthalate (PBT), or polyphenylene sulfide (PPS).

The case 31 and the cap cover 21 are made of resin. The case 31 and the cap cover 21 are made of an absorbent resin material that absorbs laser energy.

As the absorbent resin material described above, a material formed by adding a coloring agent having laser absorbing property to the above-described various translucent resin materials, for example. Examples of the coloring agent to be added include a carbon material such as carbon black, and an inorganic coloring agent such as composite oxide pigment.

The case 31 and the cap cover 21 are bonded to each other via the intermediate case 41. The case 31 and the intermediate case 41 are fixed to each other by welding. The intermediate case 41 and the cap cover 21 are fixed to each other by welding.

The cap cover 21 is formed with an opening 26 through which the detection light A and the return light B pass. The protection cover 25 is mounted on the opening 26. The protection cover 25 is made of a material (e.g., transparent resin) that can pass the detection light A and the return light B.

The light emitting diode 61 is provided as a light emitting unit emitting the detection light A. The light emitting diode 61 includes a light emitting diode chip 62 emitting the detection light A, and a translucent resin layer 64 sealing the light emitting diode chip 62. The light projecting lens 66 is arranged to be opposite to the light emitting diode 61. The light projecting lens 66 is provided on the optical path of the detection light A between the light emitting diode 61 and the reflection mirror 23.

The photodiode 51 is provided as a light receiving unit receiving the return light B. The photodiode 51 includes a base 53, a photodiode chip 52 mounted on the main surface of the base 53 for receiving the return light B, and a translucent resin layer 54 sealing the photodiode chip 52 on the main surface of the base 53. The light receiving lens 56 is arranged to face the photodiode 51. The light receiving lens 56 is provided on the optical path of the return light B between the photodiode 51 and the reflection mirror 23.

In the photoelectric sensor 10 that is the retroreflective photoelectric sensor having two lenses, the light emitting diode 61 and the light projecting lens 66 are provided in a space different from a space in which the photodiode 51 and the light receiving lens 56 are provided, due to a partition wall 27 provided in the case 31.

The reflection mirror 23 is provided on the side reverse to the photodiode 51 with respect to the light receiving lens 56. The reflection mirror 23 is provided on the side reverse to the light emitting diode 61 with respect to the light projecting lens 66. The reflection mirror 23 has a reflection surface 23p reflecting the detection light A and the return light B.

The detection light A emitted from the light emitting diode 61 is converted into parallel light by the light projecting lens 66, and advances to the cap cover 21 from the case 31. The advancing direction of the detection light A is changed at an angle of 90 degrees by the reflection mirror 23. Then, the detection light A is emitted through the protection cover 25 to the outside. The detection light A emitted to the outside is reflected by the retroreflector 14 (see Fig. 1) to become the return light B. The advancing direction of the return light B entering the cap cover 21 through the protection cover 25 is changed at an angle of 90 degrees by the reflection mirror 23. The return light B is converted into convergent light on the light receiving lens 56, and enters the photodiode 51.

Fig. 6 is a sectional view illustrating the partially enlarged sensor head of the photoelectric sensor in Fig. 2. Fig. 6 illustrates the cross-section of the case 31, the intermediate case 41, and the cap cover 21, wherein the coupled portion of these members is mainly illustrated.

With reference to Figs. 4 to 6, the case 31, the intermediate case 41 and the cap cover 21 are combined to one another to form the resin case 20 in the present embodiment.

The case 31 has a bonding surface 31c. The bonding surface 31c is formed to face the intermediate case 41. The bonding surface 31c has an annularly round shape as viewed from front. The bonding surface 31c has an annularly round shape on the same plane. The bonding surface 31c has an annularly round shape on a plane orthogonal to the advancing direction of the detection light A between the light projecting lens 66 and the reflection mirror 23 and the advancing direction of the return light B between the light receiving lens 56 and the reflection mirror 23. The bonding surface 31c has a round shape formed by combining two curved portions and two linear portions.

The intermediate case 41 has a thin annular shape. The intermediate case 41 has the annular shape corresponding to the round shape of the bonding surface 31c. The intermediate case 41 has an end face 41a and an end face 41b. The end face 41a faces the cap cover 21. The end face 41b is provided on the reverse side of the end face 41a, and faces the case 31.

The cap cover 21 is provided reverse to the case 31 with respect to the intermediate case 41. The cap cover 21 stands on the end face 41a of the intermediate case 41. The cap cover 21 has a shape having a diameter smaller than that of the intermediate case 41 and the case 31, when the sensor head 12 is viewed from the cap cover 21.

The cap cover 21 has a side portion 21a and a top portion 21b as its component.
The side portion 21a is provided to stand from the intermediate case 41. The side portion 21a cylindrically extends to be apart from the end face 41a of the intermediate case 41. The side portion 21a extends cylindrically in the advancing direction of the detection light A between the light projecting lens 66 and the reflection mirror 23 and the advancing direction of the return light B between the light receiving lens 56 and the reflection mirror 23. The opening 26 is formed on the side portion 21a.

The top portion 21b is provided on a leading end of the side portion 21a standing from the intermediate case 41. The top portion 21b is provided so as to close an open end of the side portion 21a extending cylindrically from the end face 41a. The side portion 21a and the top portion 21b cross each other on the position facing the bonding surface 31c of the case 31 through the intermediate case 41. The side portion 21a and the top portion 21b cross each other on the position apart from the reflection mirror 23 with respect to the bonding surface 31c. The side portion 21a and the top portion 21b cross each other on a position apart from the protection cover 25 with respect to the bonding surface 31c.

The cap cover 21 has a bonding surface 21c. The bonding surface 21c faces the intermediate case 41. The bonding surface 21c faces the end face 41a of the intermediate case 41. The bonding surface 21c faces the bonding surface 31c of the case 31 through the intermediate case 41.

The intermediate case 41 is assembled to the case 31 in such a manner that the end face 41b is superimposed on the bonding surface 31c. The intermediate case 41 is bonded to the bonding surface 31c by welding the resin forming the intermediate case 41 and the resin forming the case 31. The intermediate case 41 is also assembled to the cap cover 21 in such a manner that the end face 41 a is superimposed on the bonding surface 21c. The intermediate case 41 is bonded to the bonding surface 21c by welding the resin forming the intermediate case 41 and the resin forming the cap cover 21.

In the resin case 20 according to the present embodiment, the height (height H in Figs. 5 and 6) of the position where the side portion 21 a and the top portion 21 b cross each other with the bonding surface 31 c being defined as a reference is the same on any position facing the bonding surface 31 c. Specifically, the height H of the position where the side portion 21 a and the top portion 21 b cross each other is the same on any position of the circumference of the bonding surface 31 c.

In the present embodiment, the top portion 21b has a sheet-like shape orthogonal to the advancing direction of the detection light A between the light projecting lens 66 and the reflection mirror 23 and the advancing direction of the return light B between the light receiving lens 56 and the reflection mirror 23. The top portion 21b has a sheet-like shape parallel to the bonding surface 31c. The top portion 21b has a sheet-like shape, and crosses the side portion 21a with the height H on the entire circumference.

The reflection mirror 23 is stored in the cap cover 21 in order that the reflection surface 23p extends obliquely with respect to the bonding surface 31c. The reflection mirror 23 is supported with a tilting posture with respect to the sheet-like top portion 21b. A free space 28 having an approximately triangular cross-section is formed between the reflection mirror 23 and the top portion 21b as illustrated in Fig. 3. The free space 28 is formed on the backside of the reflection mirror 23 as viewed from the reflection surface 23p.

In the present embodiment, the case where the cap cover 21 has the flat top portion 21b is described. However, the present invention is not limited thereto. For example, the top portion 21b may have a shape hemispherically projecting in the axial direction of the side portion 21a as a whole, or the top portion 21b may be formed with a recessed portion or a projecting portion on its center, so long as the height H of the position where the side portion 21a and the top portion 21b cross each other is the same on the whole circumference of the top portion 21b.

In Fig. 5, a plane 120 parallel to the bonding surface 31c is supposed. When the cap cover 21 is cut along the plane 120, the side portion 21a has a cross-sectional shape 130 same as or similar to the round shape of the bonding surface 31c. The side portion 21a is formed so as to stand from the end face 41a just above the bonding surface 31c at right angles to the bonding surface 31c, and to cross the top portion 21b on its tip end.

The cap cover 21 has a chamfered portion 22. The chamfered portion 22 is formed on the position where the side portion 21a and the top portion 21b cross each other. The chamfered portion 22 is formed so as to cut the corner of the side portion 21a and the top portion 21b in a curved surface. The size of the chamfered portion 22 is preferably R1.0 (mm) or more.

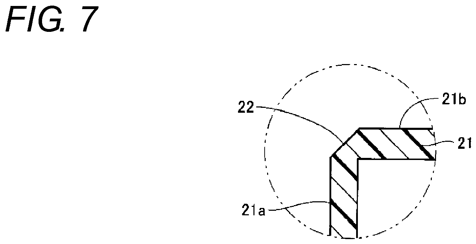

Fig. 7 is a sectional view illustrating a modification of the chamfered portion formed on the cap cover. Fig. 7 illustrates the cross-section of the cap cover 21 corresponding to the range enclosed by a two-dot chain line VII in Fig. 6.

With reference to Fig. 7, the chamfered portion 22 is formed by cutting the corner of the side portion 21a and the top portion 21b to have an inclined plane. The size of the chamfered portion 22 is preferably C1.0 (mm) or more.

The configuration of the resin case 20 and the photoelectric sensor 10 according to the embodiment of the present invention described above will collectively be described.

The resin case 20 as the resin part according to the present embodiment includes the case 31 having the bonding surface 31 c, made of resin, and serving as a first member; the intermediate case 41 bonded to the bonding surface 31c by welding, made of resin that can transmit laser light, and serving as an intermediate member; and the cap cover 21 arranged on the opposite side of the case 31 with respect to the intermediate case 41 to stand on the intermediate case 41, made of resin, and serving as a second member. The cap cover 21 includes the side portion 21a standing from the intermediate case 41, and the top portion 21b crossing the side portion 21a on the position facing the bonding surface 31c via the intermediate case 41. The height H of the position where the side portion 21a and the top portion 21b cross each other with the bonding surface 31c being defined as a reference is the same on any position facing the bonding surface 31c.

The resin case 20 according to the present embodiment is a resin part molded by melting the case 31, serving as an absorbent resin material, on the backside of the intermediate case 41, serving as a translucent resin material, by the irradiation of laser light. The cap cover 21 serving as the member on the optical path of the laser light is a colored and non-transparent resin member that cannot transmit laser light. The cap cover 21 has a melt avoiding structure for keeping the cap cover 21 with a temperature less than the melting temperature of the colored and non-transparent member during the reception of the laser light.

The photoelectric sensor 10 according to the present embodiment includes the case 31, the intermediate case 41, and the cap cover 21 as described above, and also includes the light emitting diode 61 serving as a light projecting unit emitting light, the photodiode 51 serving as the light receiving unit receiving light, and the reflection mirror 23 serving as a mirror that reflects the light emitted from the light emitting diode 61 to the object to be detected, and reflects the light emitted from the light emitting diode 61 to the object to be detected toward the photodiode 51. The case 31 stores the light emitting diode 61 and the photodiode 51. The cap cover 21 stores the reflection mirror 23, and is fixed to the case 31 via the intermediate case 41.

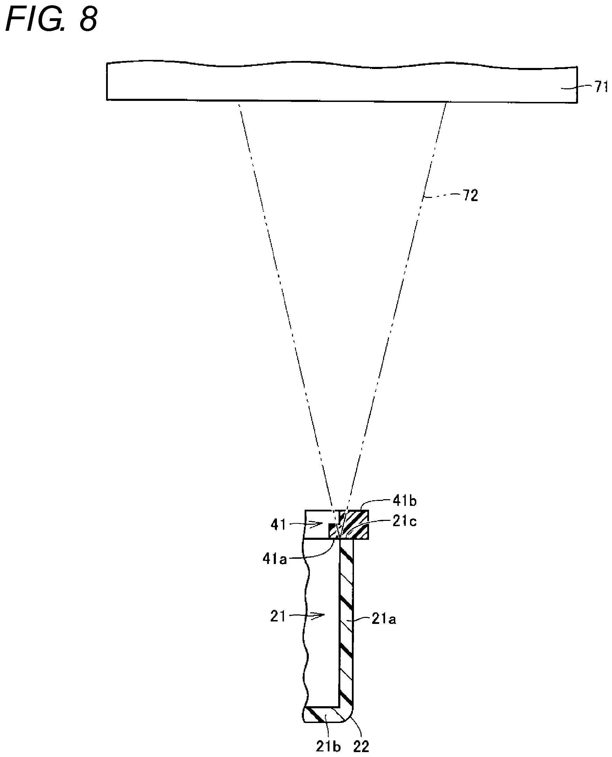

A method of manufacturing the resin case 20 by bonding the case 31, the intermediate case 41, and the cap cover 21 to one another will next be described. Figs. 8 to 10 are sectional views illustrating a process in the method of manufacturing the resin case in Fig. 6.

With reference to Fig. 8, the intermediate case 41 is firstly bonded to the cap cover 21 by welding.

Specifically, the intermediate case 41 is assembled to the cap cover 21 with the end face 41a being superimposed on the bonding surface 21c. A laser head 71 is positioned on the place opposite to the bonding surface 21c of the cap cover 21 via the intermediate case 41. The bonding surface 21c is irradiated with the laser light 72 from the laser head 71, and simultaneously, the laser head 71 is moved to scan the laser light 72 along the bonding surface 21c. Since the laser light 72 is absorbed by the cap cover 21 through the intermediate case 41, the bonding surface 21c generates heat. Thus, the resin forming the cap cover 21 and the resin forming the intermediate case 41 are melted, whereby the intermediate case 41 is bonded to the bonding surface 21c.

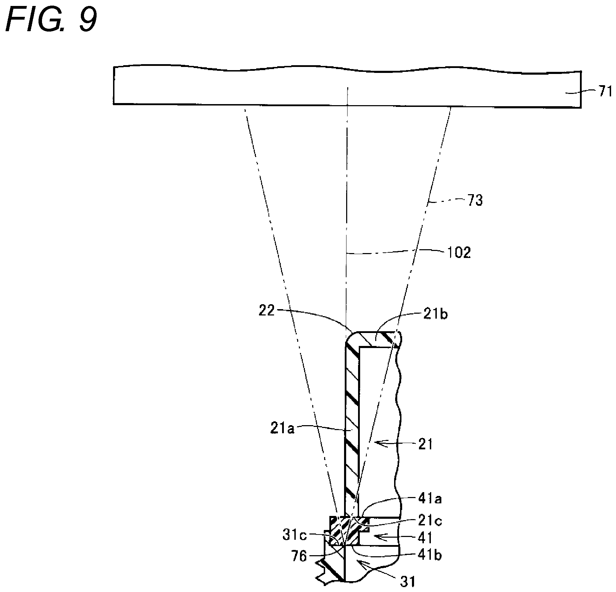

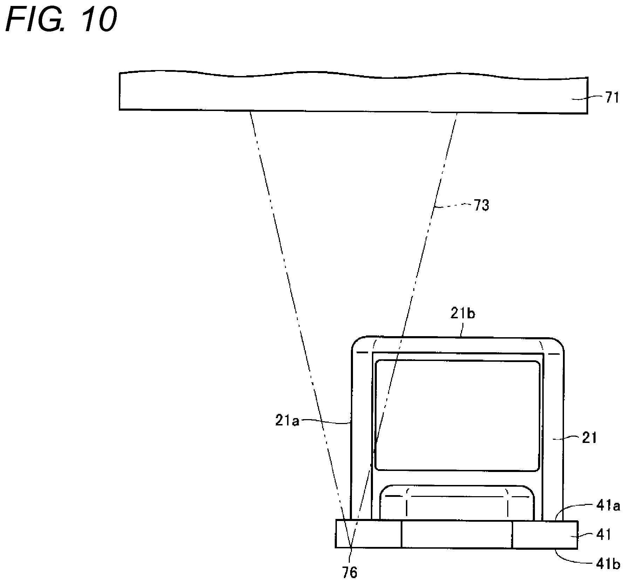

Then, the intermediate case 41 is bonded to the case 31 by welding with reference to Figs. 9 and 10.

Specifically, the intermediate case 41 to which the cap cover 21 is bonded in the previous step is assembled to the cap cover 21 with the end face 41b being superimposed on the bonding surface 31c. The laser head 71 is positioned on the place opposite to the bonding surface 31c of the case 31 via the intermediate case 41.

The bonding surface 31c is irradiated with the laser light 73 from the laser head 71, and simultaneously, the laser head 71 is moved to scan the laser light along the bonding surface 31c. In this case, the laser head 71 is moved to keep the relationship in which the optical axis 102 of the laser light 73 is orthogonal to the bonding surface 31c. In this step, the laser light 73 is emitted to the bonding surface 31c over the cap cover 21. Therefore, some laser light 73 is blocked by the cap cover 21 on the position where the side portion 21 a and the top portion 21b cross each other. Since the laser light 73 is absorbed by the case 31 through the intermediate case 41, the bonding surface 31c generates heat. Thus, the resin forming the case 31 and the resin forming the intermediate case 41 are melted, whereby the intermediate case 41 is bonded to the bonding surface 31 c.

The type of the laser light used in the above-described step is appropriately selected in consideration of the material, the bonding area, and productivity of the case 31, the intermediate case 41, and the cap cover 21. Examples of the laser light selected as described above include semiconductor laser, and infrared laser using YAG laser.

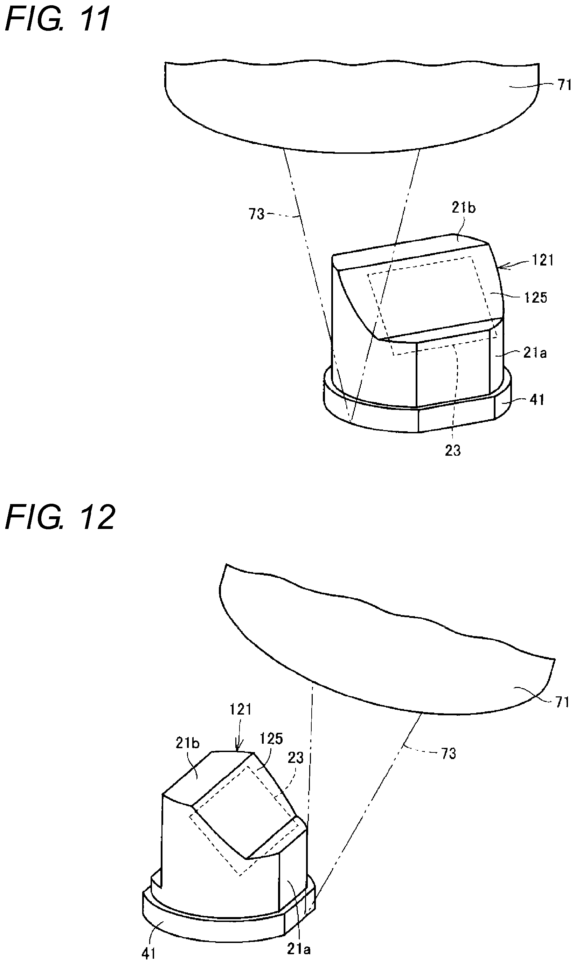

Fig. 11 is a perspective view illustrating a process of a method of manufacturing a resin case according to a comparative example. Fig. 12 is a perspective view illustrating a process of another method of manufacturing a resin case according to a comparative example. Figs. 11 and 12 illustrate the step of bonding the case 31 to the intermediate case 41 by welding as described with reference to Figs. 9 and 10.

With reference to Figs. 11 and 12, a resin case according to the present comparative example includes a cap cover 121 instead of the cap cover 21. The cap cover 121 has a side portion 21a and a top portion 21b as its component. The cap cover 121 is formed with a cutout 125 along the reflection mirror 23.

In the process illustrated in Fig. 11, the laser head 71 is moved to keep the relationship in which the optical axis of the laser light 73 is orthogonal to the bonding surface 31c. At this time, when some laser light 73 is blocked by the cap cover 121, the resin might be melted or burned on a focal position of the laser light 73, i.e., on the cutout 125 close to the bonding surface 31c. For example, when the energy density of the laser light on the position blocking the laser light is larger than 1/3 of the energy density of the laser light on the focal position, the resin can be melted and burned more significantly.

Since the cutout 125 is formed on the cap cover 121, the height of the position where the laser light 73 is blocked is changed upon scanning the laser light along the bonding surface 31c. Therefore, the energy of the laser light 73 transmitted to the bonding surface 31c also changes. Accordingly, in the present comparative example, a complicated control for the irradiation energy has to be provided in order to make the energy of the laser light 73 transmitted to the bonding surface 31c uniform.

In order to prevent the laser light 73 from being blocked by the cover 121, the laser head 71 is moved such that the optical axis of the laser light 73 obliquely crosses the bonding surface 31c in the process illustrated in Fig. 12. In this case, cost for facilities to the irradiation of the laser light may increase, or the control to move the laser head 71 may be complicated.

On the other hand, in the resin case 20 according to the present embodiment, the height of the position where the side portion 21a and the top portion 21b cross each other with the bonding surface 31c being defined as a reference is the same on any position facing the bonding surface 31c as illustrated in Figs. 9 and 10. This configuration allows the height from the bonding surface 31c to the position where the cap cover 21 blocks the laser light 73 to be the same on any position facing the bonding surface 31c. Accordingly, the distance from the focal position of the laser light 73 (bonding surface 31c) to the position where the cap cover 21 blocks the laser light 73 on the scanning path of the laser light 73 is sufficiently secured, whereby this configuration can prevent the cap cover 21 from being melted or burned.

In the resin case 20 according to the present embodiment, when the cap cover 21 is cut along the plane 120 parallel to the bonding surface 31c, the side portion 21a has the cross-section same as or similar to the round shape of the bonding surface 31 c. Therefore, the appearance of the cap cover 21 can be close to the scanning path of the laser light 73. According to this configuration, some of the laser light 73 is blocked by the cap cover 21 to generate energy loss of the laser light 73 transmitted to the bonding surface 31c, but the amount of the loss becomes constant on all positions of the bonding surface 31c. Consequently, the intermediate case 41 can be bonded to the bonding surface 31c with uniform quality without making a complicated control for the irradiation energy of the laser light.

In the resin case 20 according to the present embodiment, the chamfered portion 22 is formed on the position where the side portion 21a and the top portion 21b of the cap cover 21 cross each other. This configuration can more effectively prevent the cap cover 21 from being melted or burned on the position where the side portion 21a and the top portion 21b cross each other.

In the method of manufacturing the resin case 20 according to the present embodiment, the laser head 71 is moved to keep the relationship in which the optical axis 102 of the laser light 73 is orthogonal to the bonding surface 31c. According to this configuration, the facility for the irradiation of the laser light can easily be formed. For example, a facility can be installed in which a plurality of resin parts undergoing the welding process using the laser light are arranged with the welding surface being directed in one direction, and the laser head 71 makes parallel shift. With this, a variety of welding processes can continuously be executed by the same facility.

The resin case 20, the photoelectric sensor 10, and its manufacturing method according to the embodiment of the present invention described above can prevent the cap cover 21 from being locally melted or burned due to the irradiation of the laser light. Therefore, the appearance of the resin case 20 can be finished with good quality. The variation in the energy of the laser light transmitted to the bonding surface 31c can be prevented, whereby the resin case 20 can be manufactured with a simple manufacturing process. From these reasons, the high-quality photoelectric sensor 10 can be produced with reduced manufacturing cost.

In the present embodiment, the present invention is applicable to a retroreflective photoelectric sensor having two lenses. However, the present invention is not limited thereto. The present invention is also applicable to a transmissive photoelectric sensor in which a projector having a light projecting unit and an optical receiver having a light receiving unit are used as a pair. In the transmissive photoelectric sensor, the projector and the optical receiver are arranged to be opposite to each other in order that light from the projector enters the optical receiver. When an object to be measured blocks light between the projector and the optical receiver, an amount of light entering the optical receiver decreases. Based upon the decrease in the amount of light, the presence of the object to be measured is detected.

The present invention is not limited to the photoelectric sensor. The present invention is also applicable to various resin parts having a plurality of bonded resin members by utilizing a bonding method of resin using laser light. Preferably, the resin part according to the present invention is used as a casing of an electronic component. The first member and the second member in the present invention are not necessarily different members. A single member formed by combining the first member and the second member may be employed.

The embodiment of the present invention described above should be considered in all respects as illustrative and not restrictive of the present invention.

The present invention is applied to a resin case of a photoelectric sensor, for example.

## Claims

1. A photoelectric sensor (10) comprising:
a first member (31) having a bonding surface (31c), and made of an absorbent resin material that absorbs laser energy;
an intermediate member (41) bonded to the bonding surface (31c) by welding, and made of resin that can transmit laser light; and
a second member (21) arranged on the other side of the first member (31) with respect to the intermediate member (41), standing on the intermediate member (41), and made of an absorbent resin material that absorbs laser energy, the second member (21) having an outer contour that is located inward of the outer contours of the intermediate member (41) and the first member (31) when the photoelectric sensor (10) is viewed from the second member (21), wherein
the second member (21) has a side portion (21a) standing from the intermediate member (41), and a top portion (21b) crossing the side portion (21a) on a position facing the bonding surface (31c) via the intermediate member (41), and
a height of a position where the side portion (21a) and the top portion (21b) cross each other with the bonding surface (31c) being defined as a reference is the same on any position facing the bonding surface (31c).

2. The photoelectric sensor (10) according to claim 1, wherein
the first member (31) and the intermediate member (41) are bonded along the bonding surface (31c) that is annular, and
the side portion (21a) has a cross-section same as or similar to the round shape of the bonding surface (31c) when the second member (21) is cut along a plane parallel to the bonding surface (31c).

3. The photoelectric sensor (10) according to claim 1 or 2, wherein a chamfered portion (22) is formed on the position where the side portion (21a) and the top portion (21b) cross each other.

4. The photoelectric sensor (10) according to claim 3, wherein the chamfered portion (22) is formed by chamfering the position where the side portion (21a) and the top portion (21b) cross each other in an inclined plane or in a curved plane.

5. The photoelectric sensor (10) according to any one of claims 1 to 4, further comprising:
at least either one of a light projecting unit (61) emitting light and a light receiving unit (51) receiving light; and
a mirror (23) that reflects the light emitted from the light projecting unit (61) toward an object to be detected, or reflects the light emitted from the light projecting unit (61) to the object toward the light receiving unit (51), wherein
the first member (31) is a body case storing at least either one of the light projecting unit (61) and the light receiving unit (51), and
the second member (21) is a cover member that stores the mirror (23), and the cover member is fixed to the body case via the intermediate member (41).

6. The photoelectric sensor (10) according to claim 5, wherein the mirror (23) has a reflection surface reflecting light, and is stored in the cover member in order that the reflection surface extends obliquely with respect to the bonding surface (31c).

7. A method of manufacturing the photoelectric sensor (10) according to any one of claims 1 to 4, the method comprising:
a step of bonding the intermediate member (41) to the second member (21) by welding;
a step of positioning a laser head on a place where the head faces the bonding surface (31c) with the intermediate member (41) being superimposed on the bonding surface (31c); and
a step of irradiating the bonding surface (31c) with laser light across the second member (21), while moving the laser head and the resin part relatively to keep a relationship in which an optical axis of the laser light is orthogonal to the bonding surface (31c).

## Patentansprüche

1. Photoelektrischer Sensor (10), welcher aufweist:
ein erstes Element (31), das eine Befestigungsfläche (31c) aufweist und aus einem absorbierenden Kunststoffmaterial hergestellt ist, welches Laserenergie absorbiert;
ein Zwischenelement (41), das an der Befestigungsfläche (31c) durch Schweißen befestigt ist und aus einem Kunststoff hergestellt ist, der Laserlicht transmittieren kann; und
ein zweites Element (21), das auf der anderen Seite des ersten Elements (31) mit Bezug auf das Zwischenelement (41) angeordnet ist, welches auf dem Zwischenelement (41) steht und aus einem absorbierenden Kunststoffmaterial hergestellt ist, welches Laserenergie absorbiert, wobei das zweite Element (21) eine äußere Kontur aufweist, die innerhalb der äußeren Kontur des Zwischenelements (41) und des ersten Elements (31) angeordnet ist, wenn der photoelektrische Sensor (10) von dem zweiten Element (21) aus betrachtet wird, wobei
das zweite Element (21) einen Seitenabschnitt (21a), der auf dem Zwischenelement (41) steht, und einen oberen Abschnitt (21b) aufweist, der den Seitenabschnitt (21a) an einer Position gegenüber der Befestigungsfläche (31c) über das Zwischenelement (41) kreuzt, und
eine Höhe einer Position, an der der Seitenabschnitt (21a) und der obere Abschnitt (21b) einander kreuzen, wobei die Befestigungsfläche (31c) als eine Referenz definiert ist, die gleiche an jeder Position ist, die der Befestigungsfläche (31c) gegenüberliegt.

2. Photoelektrischer Sensor (10) gemäß Anspruch 1, wobei
das erste Element (31) und das Zwischenelement (41) entlang der Befestigungsfläche (31c) verbunden sind, die ringförmig ist, und
der Seitenabschnitt (21a) einen Querschnitt hat, der gleich oder ähnlich der runden Form der Befestigungsfläche (31c) ist, wenn das zweite Element (21) entlang einer Ebene parallel zu der Befestigungsfläche (31c) geschnitten wird.

3. Photoelektrischer Sensor (10) gemäß Anspruch 1 oder 2, wobei ein abgeschrägter Abschnitt (22) an einer Position gebildet ist, an der der Seitenabschnitt (21a) und der obere Abschnitt (21b) einander kreuzen.

4. Photoelektrischer Sensor (10) gemäß Anspruch 3, wobei der abgeschrägte Abschnitt (22) durch Abschrägen der Position gebildet wird, an der der Seitenabschnitt (21a) und der obere Abschnitt (21b) einander in einer geneigten Ebene oder in einer gekrümmten Ebene kreuzen.

5. Photoelektrischer Sensor (10) gemäß einem der Ansprüche 1 bis 4, welcher ferner aufweist:
zumindest eine von einer Lichtprojektionseinheit (61), die Licht emittiert, und einer Lichtempfangseinheit (51), die Licht empfängt; und
einen Spiegel (23), der Licht, das von der Lichtprojektionseinheit (61) in Richtung eines zu erfassenden Objekts emittiert wird, reflektiert, oder das Licht, das von der Lichtprojektionseinheit (61) zu dem Objekt emittiert wird in Richtung der Lichtempfangseinheit (51) reflektiert, wobei
das erste Element (31) ein Hauptgehäuse ist, das zumindest eine von der Lichtprojektionseinheit (61) und der Lichtempfangseinheit (51) aufnimmt, und
das zweite Element (21) ein Abdeckelement ist, das den Spiegel (23) aufnimmt, und das Abdeckelement an dem Hauptgehäuse über das Zwischenelement (41) fixiert ist.

6. Photoelektrischer Sensor (10) gemäß Anspruch 5, wobei der Spiegel (23) eine Reflexionsfläche aufweist, die Licht reflektiert und in dem Abdeckelement aufgenommen ist, so dass die Reflexionsfläche sich schräg mit Bezug auf die Befestigungsfläche (31c) erstreckt.

7. Verfahren zum Herstellen des photoelektrischen Sensors (10) gemäß einem der Ansprüche 1 bis 4, wobei das Verfahren aufweist:
einen Schritt eines Befestigens des Zwischenelements (41) an dem zweiten Element (21) durch Schweißen;
einen Schritt eines Positionierens eines Laserkopfs an einem Ort, an dem der Kopf der Befestigungsfläche (31c) gegenüberliegt, wobei das Zwischenelement (41) der Befestigungsfläche (31c) überlagert ist; und
einen Schritt eines Beleuchtens der Befestigungsfläche (31c) mit Laserlicht über das zweite Element (21), während der Laserkopf und das Kunststoffteil relativ bewegt werden, um eine Beziehung aufrechtzuerhalten, in welcher die optische Achse des Laserlichts orthogonal zu der Befestigungsfläche (31c) ist.

## Revendications

1. Capteur photoélectrique (10) comprenant :
un premier élément (31) présentant une surface de liaison (31c), et constitué d'une matière de type résine absorbante qui absorbe une énergie laser ;
un élément intermédiaire (41) lié à la surface de liaison (31c) par soudage, et constitué d'une résine qui peut transmettre une lumière laser ; et
un second élément (21) disposé de l'autre côté du premier élément (31) par rapport à l'élément intermédiaire (41), se trouvant sur l'élément intermédiaire (41), et constitué d'une matière de type résine absorbante qui absorbe une énergie laser, le second élément (21) ayant un contour extérieur qui se situe vers l'intérieur par rapport aux contours extérieurs de l'élément intermédiaire (41) et du premier élément (31), lorsque le capteur photoélectrique (10) est vu depuis le second élément (21), dans lequel :
le second élément (21) comporte une partie latérale (21a) se dressant à partir de l'élément intermédiaire (41), et une partie supérieure (21b) rencontrant la partie latérale (21a) à une position faisant face à la surface de liaison (31c) par le biais de l'élément intermédiaire (41), et
une hauteur de position où la partie latérale (21a) et la partie supérieure (21b) se rencontrent l'une l'autre, la surface de liaison (31c) étant définie comme une référence, est la même à n'importe quelle position faisant face à la surface de liaison (31c).

2. Capteur photoélectrique (10) selon la revendication 1, dans lequel :
le premier élément (31) et l'élément intermédiaire (41) sont liés le long de la surface de liaison (31c) qui est annulaire, et
la partie latérale (21a) est de section transversale identique ou similaire à la forme ronde de la surface de liaison (31c), lorsque le second élément (21) est coupé suivant un plan parallèle à la surface de liaison (31c).

3. Capteur photoélectrique (10) selon la revendication 1 ou 2, dans lequel une partie chanfreinée (22) est formée à la position où la partie latérale (21a) et la partie supérieure (21b) se rencontrent.

4. Capteur photoélectrique (10) selon la revendication 3, dans lequel la partie chanfreinée (22) est formée par chanfreinage de la position où la partie latérale (21a) et la partie supérieure (21b) se rencontrent en un plan incliné ou en un plan incurvé.

5. Capteur photoélectrique (10) selon l'une quelconque des revendications 1 à 4, comprenant en outre :
l'une et/ou l'autre d'une unité de projection de lumière (61) émettant de la lumière et d'une unité de réception de lumière (51) recevant de la lumière ; et
un miroir (23) qui réfléchit la lumière émise depuis l'unité de projection de lumière (61) vers un objet à détecter, ou qui réfléchit la lumière émise depuis l'unité de projection de lumière (61) vers l'objet, en direction de l'unité de réception de lumière (51), dans lequel :
le premier élément (31) est un boîtier formant corps contenant l'une et/ou l'autre de l'unité de projection de lumière (61) et de l'unité de réception de lumière (51), et
le second élément (21) est un élément formant couvercle qui contient le miroir (23), et l'élément formant couvercle est fixé au boîtier formant corps par le biais de l'élément intermédiaire (41).

6. Capteur photoélectrique (10) selon la revendication 5, dans lequel le miroir (23) présente une surface de réflexion réfléchissant la lumière, et est contenu dans l'élément formant couvercle, afin que la surface de réflexion s'étende obliquement par rapport à la surface de liaison (31c).

7. Procédé de fabrication du capteur photoélectrique (10) selon l'une quelconque des revendications 1 à 4, le procédé comprenant :
une étape consistant à lier l'élément intermédiaire (41) au second élément (21) par soudage ;
une étape consistant à positionner une tête laser à un emplacement où la tête fait face à la surface de liaison (31c), l'élément intermédiaire (41) étant superposé à la surface de liaison (31c) ; et
une étape consistant à exposer la surface de liaison (31c) à la lumière laser à travers le second élément (21), tout en déplaçant la tête laser et la partie en résine l'une par rapport à l'autre, pour maintenir une relation dans laquelle un axe optique de la lumière laser est orthogonal à la surface de liaison (31c).
